Europäisches Patentamt

**European Patent Office**

Office européen des brevets

(19)

(11) Publication number: **0 011 083**
**B1**

(12) # EUROPEAN PATENT SPECIFICATION

(45) Date of publication of patent specification: **04.08.82**

(21) Application number: **79102626.3**

(22) Date of filing: **24.07.79**

(51) Int. Cl.³: **H 01 L 31/04, H 01 L 31/02**

(54) Photoelectric device.

(30) Priority: 26.07.78 JP 91295/78
26.07.78 JP 91296/78
26.07.78 JP 91297/78
26.07.78 JP 91298/78
26.07.78 JP 91299/78
26.07.78 JP 91300/78
26.07.78 JP 91301/78

(43) Date of publication of application:
28.05.80 Bulletin 80/11

(45) Publication of the grant of the patent:
04.08.82 Bulletin 82/31

(84) Designated Contracting States:
DE FR GB NL

(56) References cited:
FR - A - 1 174 575
US - A - 3 284 241
US - A - 3 781 549
US - A - 3 855 004
US - A - 4 051 465

(73) Proprietor: TDK ELECTRONICS CO., LTD.
13-1, Nihonbashi 1-chome
Chuo-ku Tokyo 103 (JP)

(73) Proprietor: Toda, Kohji
C-209, No. 2069, Futaba 1-chome
Yokusuka-shi Kanagawa-ken (JP)

(72) Inventor: Toda, Kohji
C-209, No.2069 Futaba 1-chome
Yokosuka-shi Kanagawa-ken (JP)
Inventor: Matsufuji, Isao
TDK Electronics Co., Ltd. 13-1, Nihonbashi 1-chome
Chuo-ku Tokyo 103 (JP)
Inventor: Takahashi, Koji
TDK Electronics Co., Ltd. 13-1, Nihonbashi 1-chome
Chuo-ku Tokyo 103 (JP)

(74) Representative: Wächtershäuser, Günter, Dr.
Gewürzmühlstrasse 5
D-8000 München 22 (DE)

Courier Press, Leamington Spa, England.

Photoelectric device

## Background of the invention

The present invention relates to a photoelectric device. More particularly, it relates to a photoelectric device in which an electrically conductive layer is formed on an oxide comprising lead oxide PbO and chromium oxide $Cr_2O_3$.

It has been well known to use widely photoelectric devices utilizing p-n or p-n-p junction of semiconductors or junction of a semiconductor and a metal. These photoelectric devices need not receive outer electromotive force, because electromotive force is generated from the photoelectric device by exposing it to incident ray.

Such a photoelectric characteristic has never been reported for a dielectric substance. It has been known that SbS (I) has photoconductivity. However, it is necessary to use an outer electromotive force for passing photocurrent.

US-Patents 3855004 and 4051465 describe a dielectric substance, which upon previous application of an outer pulse voltage generates an electromotive force when exposed to light.

## Summary of the invention

It is the object of the present invention to provide a photoelectric device on the basis of a dielectric substance which generates an electromotive force upon exposure to incident rays without application of an outer electromotive force.

The foregoing and other objects of the present invention have been attained by providing a photoelectric device in which an electroconductive layer is formed on a surface of an oxide substrate comprising lead oxide and chromium oxide.

## Brief description of the drawings

Figure 1 is a graph of variations of output voltage to laser power ($4880 \times 10^{-8}$ cm incident light);

Figures 2 to 8 respectively show graphs of variations of electromotive force to contents of various additives incorporated in the oxide substrate.

## Detailed description of the preferred embodiments

In accordance with the photoelectric transfer device of the present invention, incident ray input to the oxide substrate is converted into current and the current is passed through the conductive layer out of the device.

The photoelectromotive force can be increased and the stability of the oxide substrate can be improved by incorporating an auxiliary component in PbO and $Cr_2O_3$.

Suitable auxiliary components include perovskite composite oxides such as $PbTiO_3$, $PbZrO_3$ as $Pb(Zr\ 1/2\ Ti\ 1/2)O_3$; monovalent metal compounds such as $K_2CO_3$, $Li_2CO_3$, $Na_2CO_3$, $Rb_2CO_3$, $Cs_2CO_3$ and $Cu_2CO_3(Cu_2O)$; pentavalent metal compounds such as $Nb_2O_5$ and $Ta_2O_5$; tetravalent metal compounds such as $TiO_2$, $SiO_2$ and $ZrO_2$; trivalent metal compounds such as $Al_2O_3$, and $In_2O_3$; hexavalent metal compounds such as $MoO_3$ and $WO_3$; and divalent metal compounds such as $BaCO_3$, $SrCO_3$ and $ZnCO_3$, $(ZnO)$.

The main components PbO and $Cr_2O_3$ are blended at a ratio of 30—99.5 mol% of PbO to 0.5—70 mol% of $Cr_2O_3$.

The auxiliary component is incorporated at each following ratio to the total of PbO and $Cr_2O_3$.

perovskite composite oxides:
up to 95 mol%.
monovalent metal compounds:
up to 80 mol% as its carbonate.
pentavalent metal compounds:
up to 55 mol% as its oxide of $M^1_2O_5$ ($M^1$: metal (V))
tetravalent metal compounds:
up to 55 mol% as its oxide of $M^2O_2$ ($M^2$: metal (IV))
trivalent metal compounds:
up to 55 mol% as its oxide of $M^3_2O_3$ ($M^3$: metal (III))
hexavalent metal compounds:
up to 60 mol% as its oxide of $M^4O_3$ ($M^4$: metal (VI))
divalent metal compounds:
up to 55 mol% as its carbonate.

The main components PbO and $Cr_2O_3$ and the auxiliary component used in the present invention are preferably fine powders suitable for preparing a sintered dielectric substance having uniform structure.

The mixture is preferably calcined at 400—500°C and pulverized into fine powder. The calcined powder is mixed with a binder and molded by a press-molding and the molded product is sintered at 650—900°C.

The surface of the sintered product is coated with a metal film such as aluminum, silver, copper or alloy, preferably by a vacuum evaporation method. A thickness of the metal film can be selected to be electroconductive such as 0.1 to 100 $\mu m$ especially about 0.5 $\mu m$. The metal film is usually formed by depositing the metal on both surfaces of the dielectric substance.

## Example 1

Lead oxide PbO and chromium oxide $Cr_2O_3$ were used as starting materials and were weighed to give a ratio for a composition of $Pb_2CrO_5$. These starting materials were blended in wet condition for 10 to 15 hours in a polyethylene pot. The mixture was dried and calcined at 400 to 500°C for 2 hours. After the calcination, the product was pulverized by a ball mill for 10 to 15 hours to obtain a powder having a particle diameter of about 1 $\mu$. The calcined powder was admixed with a binder and the mixture was press-molded under a pressure of 1000 kg/cm². The molded product was sintered at 650 to 900°C for 2 hours to obtain a sintered product. A photoelectric device is formed by coating an aluminum film on the surface of the sintered product by a vacuum evaporation method. A shape of the device is a disk having a diameter of 20 mm and a thickness of 1 mm and a disk having a diameter of 20 mm and a thickness of 0.1 mm. An electrode having a diameter of 15 mm and a thickness of 0.5 $\mu$m was formed on each of the upper and lower surfaces of the sintered substrate.

The resulting photoelectric device of the present invention was exposed to sunbeams (soft sunbeams) and the resulting photoelectromotive force was measured by a DC voltage meter. The resulting electromotive force was about 50 mV. When the incident ray was shut out to measure the electromotive force, the electromotive force of the device having a thickness of 0.1 mm was zero whereas one having a thickness of 1 mm was not zero.

That is, it was found that the photosensitivity was high in the thin film type device whereas the charge storage effect was high in the thick article.

Example 2

In accordance with the process of Example 1, a photoelectric device was prepared by the same method at the same ratio of the components except varying a thickness and its photosensitivity was measured. As a result, the photosensitivity was remarkably inferior when thickness was greater than 0.2 mm whereas the charge storage effect was increased depending upon the increase of the thickness.

Example 3

In accordance with the process of Example 1 or 2, a photoelectric device was prepared at the ratio for a composition of $Pb_5CrO_8$.

In accordance with the method of Example 1, the photoelectromotive force was measured by using sunbeams (soft sunbeams) as the light source to give 30 mV. The photosensitivity was substantially the same as that of Examples 1 and 2.

Example 4

In accordance with the process of Example 1 or 2, a photoelectric device was prepared at the ratio for a composition of $PbCrO_4$.

In accordance with the method of Example 1, photoelectromotive force was measured by using sunbeams (soft sunbeams) as the light source to give 35 mV. The photosensitivity was substantially the same with those of Example 1 or 2.

In all of the examples, excellent photoelectromotive force was given.

Each photoelectric device was prepared by the process of Example 1 by varying the ratio of PbO to $Cr_2O_3$. As a result the photoelectromotive force effect was not substantially found when a ratio of $Cr_2O_3$ was higher than 70 mol%.

The photoelectromotive force effect was not substantially found when a ratio of PbO was higher than 99.5 mol%.

The effect of the ratio of PbO to $Cr_2O_3$ is interpreted as follows. A mixed crystal of $PbCrO_4$ and $Cr_2O_3$ is formed when the content of $Cr_2O_3$ is in excess of to the ratio for $PbCrO_4$. A mixed crystal of $Pb_5CrO_8$ and PbO is formed when the content of PbO is in excess to the ratio for $Pb_5CrO_8$. A mixed crystal of a combination of compounds selected from PbO, $Cr_2O_3$, $Pb_2CrO_5$ and $Pb_5CrO_8$ is formed at a ratio in the middle range.

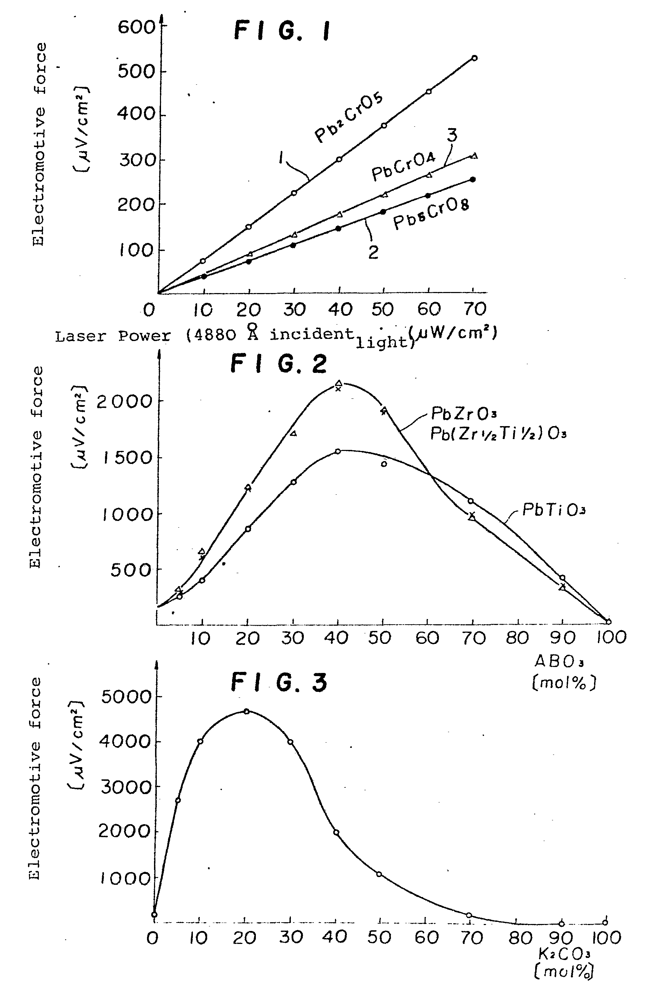

Each laser ray was applied to each of the photoelectric device of Examples 1, 3 and 4 which has a thickness of 0.1 mm and the relation of the laser power and the output voltage of the photoelectric device was measured. The results are shown in Figure 1. The intensity of the laser ray was varied in a range of 0 to 70 $\mu$W/cm² by using a filter for a wavelength of 4800 $10^{-8}$cm. The output voltage was varied depending upon the variation of the laser power as shown in Figure 1 wherein the curves (1), (2) and (3) respectively show the results of Examples 1, 2, and 3.

Example 5

Lead oxide PbO and chromium oxide $Cr_2O_3$ were used as starting materials and were weighed to give a ratio for a composition of $Pb_2CrO_5$.

A further component of $PbTiO_3$, $PbZrO_3$ or $Pb(Zr\ 1/2\ Ti\ 1/2)O_3$ was respectively incorporated at a range of less than 95 mol%.

These starting materials were blended in wet condition for 10 to 15 hours in a polyethylene pot. The mixture was dried and calcined at 400 to 500°C for 2 hours. After the calcination, the product was pulverized by a ball mill for 10 to 15 hours to obtain a powder having particle diameter of about 1 $\mu$. The calcined powder was admixed with a binder and the mixture was press-molded under a pressure of 1000 kg/cm². The molded product was sintered at 650 to 900°C for 2 hours to obtain a sintered product. A photoelectric device is formed by coating an aluminum film on the surface of the sintered product by a vacuum evaporation method. A shape of the device is a disk having a diameter of 20 mm and a thickness of 1 mm and a disk having a diameter of 20 mm and a thickness of 0.1 mm. An electrode having a diameter of 15 mm and a thickness of 0.5 $\mu$m was formed on each of the upper and lower surfaces of the sintered substrate.

Each resulting photoelectric device of the present invention was exposed to a laser beam having a laser power of 20 $\mu$W/cm$^2$ at a wavelength of $4880 \times 10^{-8}$ cm and each photoelectromotive force was measured by a DC voltage meter. The results are shown in Table 1 and plotted in Figure 1.

As it is clearly understood from Table 1 and Figure 1, the maximum value was given in a content of the further component of about 40 mol% and was higher than 1550 $\mu$V/cm$^2$ in the case of PbTiO$_3$; higher than 2140 $\mu$V/cm$^2$ in the case of PbZrO$_3$ and higher than 2100 $\mu$V/cm$^2$ in the case of Pb(Zr 1/2 Ti 1/2)O$_3$.

An electromotive force of the device was measured by masking the device from incident ray. When a thickness of the disk was 0.1 mm, the electromotive force was zero. However, when a thickness of the disk was 1 mm, it was not zero. This fact shows that a thin device has high photosensitivity whereas a thick device has high charge storage effect.

TABLE 1

| Further component mol% | Photoelectromotive force ($\mu$V/cm$^2$) | | |
|---|---|---|---|
| | PbTiO$_3$ | PbZrO$_3$ | Pb(Zr 1/2 Ti 1/2)O$_3$ |
| 0 | 150 | 150 | 150 |
| 5 | 250 | 320 | 300 |
| 10 | 400 | 650 | 600 |
| 20 | 850 | 1220 | 1200 |
| 30 | 1250 | 1700 | 1700 |
| 40 | 1550 | 2140 | 2100 |
| 50 | 1400 | 1910 | 1900 |
| 70 | 1100 | 940 | 950 |
| 90 | 400 | 310 | 300 |
| 100 | 0 | 0 | 0 |

Example 6

In accordance with the process of Example 5, each photoelectric device was prepared by blending PbO and Cr$_2$O$_3$ to give PbCrO$_4$ or Pb$_5$CrO$_8$ and adding 10 mol% of Pb(Zr 1/2 Ti 1/2)O$_3$.

As a result, the photoelectromotive forces of the devices were respectively 720 $\mu$V/cm$^2$ in the case of PbCrO$_4$ and 660 $\mu$V/cm$^2$ in the case of Pb$_5$CrO$_8$.

Example 7

Lead oxide PbO and chromium oxide Cr$_2$O$_3$ were used as starting materials and were weighed to give a ratio for a composition of Pb$_2$CrO$_5$. As an auxiliary component K$_2$CO$_3$ was incorporated at a range of 5—90 mol%.

These starting materials were blended in wet condition for 10 to 15 hours in a polyethylene pot. The mixture was dried and calcined at 400 to 500°C for 2 hours. After the calcination, the product was pulverized by a ball mill for 10 to 15 hours to obtain a powder having particle diameter of about 1 $\mu$. The calcined powder was admixed with a binder and the mixture was press-molded under a pressure of 1000 kg/cm$^2$. The molded product was sintered at 650 to 900°C for 2 hours to obtain a sintered product. A photoelectric device is formed by coating an aluminum film on the surface of the sintered product by a vacuum evaporation method. A shape of the device is a disk having a diameter of 20 mm and a thickness of 1 mm and a disk having a diameter of 20 mm and thickness of 0.1 mm. An electrode having a diameter of 15 mm and a thickness of 0.5 $\mu$m was formed on each of the upper and lower surfaces of the sintered substrate.

Each resulting photoelectric device of the present invention was exposed to laser beam having a laser power of 20 $\mu$W/cm$^2$ at a wavelength of $4880 \times 10^{-8}$ cm and each photoelectromotive force was measured by a DC voltage meter. The results are shown in Table 2 and plotted in Figure 3.

As it is clearly understood from Table 2 and Figure 3, the maximum value was given in a content of K$_2$CO$_3$ of about 20 mol% and was higher than 4700 $\mu$V/cm$^2$. An electromotive force of the device was measured by masking the device from incident ray. When the thickness of the disk was 0.1 mm, the electromotive force was zero. However, when the thickness of the disk was 1 mm, it was not zero. This fact shows that a thin device has high photosensitivity, whereas a thick device has high charge storage effect.

TABLE 2

| K$_2$CO$_3$ (mol%) | Photoelectromotive force ($\mu$V/cm$^2$) |
|---|---|
| 0 | 150 |
| 5 | 2700 |
| 10 | 4000 |
| 20 | 4700 |
| 30 | 4000 |
| 40 | 2000 |
| 50 | 1100 |
| 70 | 200 |
| 90 | 0 |
| 100 | 0 |

Example 8

In accordance with the process of Example 7, each photoelectric device was prepared by blending PbO and Cr$_2$O$_3$ to give PbCrO$_4$ or Pb$_5$CrO$_8$ and adding 10 mol% of K$_2$CO$_3$.

As a result, the photoelectromotive forces of the devices were respectively, 2820 $\mu$V/cm$^2$ in the case of PbCrO$_4$ and 2600 $\mu$V/cm$^2$ in the case of Pb$_5$CrO$_8$.

Example 9

In accordance with the process of Example 7 except using 10 mol% of Li$_2$CO$_3$, Na$_2$CO$_3$, Rb$_2$CO$_3$ or Cs$_2$CO$_3$ instead of K$_2$CO$_3$, each photoelectric device was prepared and each photoelectromotive force was measured.

In the other test, $Cu_2O$ was used instead of $K_2CO_3$. The results are shown in Table 3.

TABLE 3

| Auxiliary component (10 mol%) | Photoelectromotive force ($\mu$V/cm$^2$) |
|---|---|
| $K_2CO_3$ | 4700 |
| $Li_2CO_3$ | 3800 |
| $Na_2CO_3$ | 4200 |
| $Rb_2CO_3$ | 4000 |
| $Cs_2CO_3$ | 4050 |
| $Cu_2CO_3(Cu_2O)$ | 3900 |

Example 10

Lead oxide PbO and chromium oxide $Cr_2O_3$ were used as starting materials and were weighed to give a ratio for a composition of $Pb_2CrO_5$. As an auxiliary component, $Nb_2O_5$ was incorporated at a range of 5—80 mol%.

These starting materials were blended in wet condition for 10 to 15 hours in a polyethylene pot. The mixture was dried and calcined at 400 to 500°C for 2 hours. After the calcination, the product was pulverized by a ball mill for 10 to 15 hours to obtain a powder having particle diameter of about $1\mu$. The calcined powder was admixed with a binder and the mixture was press-molded under a pressure of 1000 kg/cm$^2$. The molded product was sintered at 650 to 900°C for 2 hours to obtain a sintered product. A photoelectric device is formed by coating an aluminum film on the surface of the sintered product by a vacuum evaporation method. A shape of the device is a disk having a diameter of 20 mm and a thickness of 1mm and a disk having a diameter of 20 mm and a thickness of 0.1 mm. An electrode having a diameter of 15 mm and a thickness of 0.5 $\mu$m was formed on each of the upper and lower surfaces of the sintered substrate.

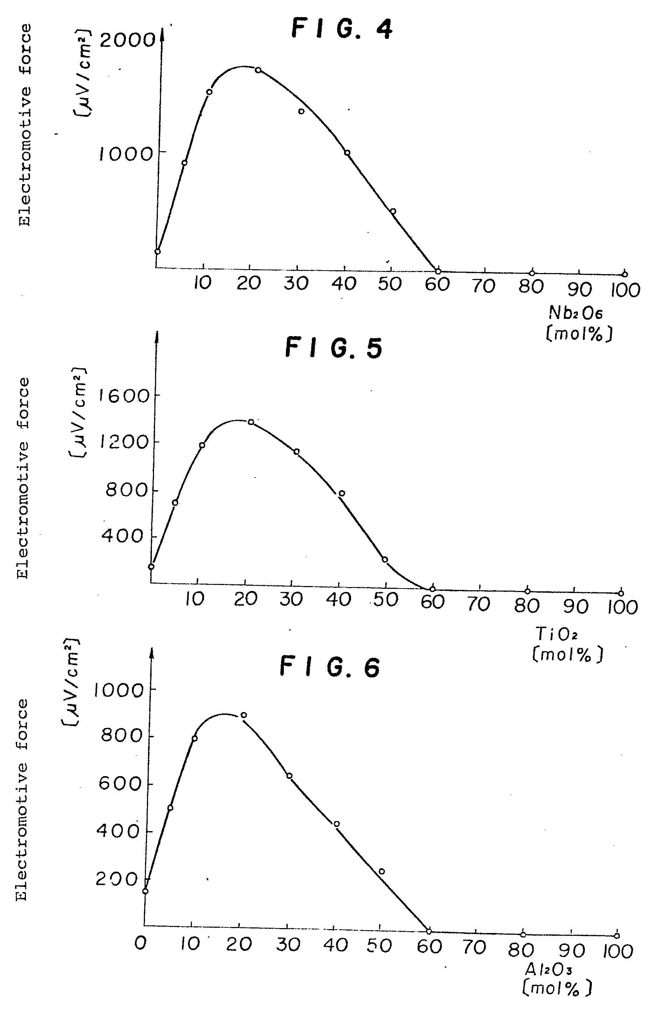

Each resulting photoelectric device of the present invention was exposed to laser beam having a laser power of 20 $\mu$W/cm$^2$ at a wavelength of $4880 \times 10^{-8}$ cm and each photoelectromotive force was measured by a DC voltage meter. The results are shown in Table 4 and plotted in Figure 4.

As it is clearly understood from Table 4 and Figure 4, the maximum value was given in a content of $Nb_2O_5$ of about 20 mol% and was higher than 1700 $\mu$V/cm$^2$. An electromotive force of the device was measured by masking the device from incident ray. When the thickness of the disk was 0.1 mm, the electromotive force was zero. However, when the thickness of the disk was 1 mm, it was not zero. This fact shows that a thin device has high photosensitivity, whereas a thick device has high charge storage effect.

TABLE 4

| $Nb_2O_5$ (mol%) | Photoelectromotive force ($\mu$V/cm$^2$) |
|---|---|
| 0 | 150 |
| 5 | 900 |
| 10 | 1500 |
| 20 | 1700 |
| 30 | 1350 |
| 40 | 1000 |
| 50 | 500 |
| 60 | 0 |
| 80 | 0 |
| 100 | 0 |

Example 11

In accordance with the process of Example 10, each photoelectric device was prepared by blending PbO and $Cr_2O_3$ to give $PbCrO_4$ or $Pb_5CrO_8$ and adding 10 mol% of $Nb_2O_5$.

As a result, the photoelectromotive forces of the devices were respectively, 900 $\mu$V/cm$^2$ in the case of $PbCrO_4$ and 720 $\mu$V/cm$^2$ in the case of $Pb_5CrO_8$.

Example 12

In accordance with the process of Example 10 except using 10 mol% of $Ta_2O_5$ instead of $Nb_2O_5$, each photoelectric device was prepared and each photoelectromotive force was measured. The results are shown in Table 5.

TABLE 5

| Auxiliary component (10 mol%) | Photoelectromotive force ($\mu$V/cm$^2$) |
|---|---|
| $Nb_2O_5$ | 1500 |
| $Ta_2O_5$ | 1400 |

Example 13

Lead oxide PbO and chromium oxide $Cr_2O_3$ were used as starting materials and were weighed to give a ratio for a composition of $Pb_2CrO_5$. As a further component, $TiO_2$ was incorporated at a range of 5—80 mol%.

These starting materials were blended in wet condition for 10 to 15 hours in a polyethylene pot. The mixture was dried and calcined at 400 to 500°C for 2 hours. After the calcination, the product was pulverized by a ball mill for 10 to 15 hours to obtain a powder having particle diameter of about $1\mu$. The calcined powder was admixed with a binder and the mixture was press-molded under a pressure of 1000 kg/cm$^2$. The molded product was sintered at 650 to 900°C for 2 hours to obtain a sintered product. A photoelectric device is formed by coating an aluminum film on the surface of the sintered product by a vacuum evaporation method. A shape of the device is a disk having a diameter of 20 mm and a thickness of 1 mm and a disk having a diameter of 20 mm and a thickness of 0.1 mm. An electrode having a diameter of 15 mm and a thickness of 0.5 $\mu$m was formed on each of the upper and lower surfaces of the sintered substrate.

Each resulting photoelectric device of the present invention was exposed to laser beam having a laser power of 20 $\mu$W/cm$^2$ at a wavelength of 4880 $10^{-8}$ cm and each photoelectromotive force was measured by a DC voltage meter. The results are shown in Table 6 and plotted in Figure 5.

As it is clearly understood from Table 6 and Figure 5, the maximum value was given in a content of $TiO_2$ of about 20 mol% and was higher than 1400 $\mu$V/cm$^2$. An electromotive force of the device was measured by masking the device from incident ray. When the thickness of the disk was 0.1 mm, the electromotive force was zero. However, when the thickness of the disk was 1 mm, it was not zero. This fact shows that a thin device has high photosensitivity, whereas a thick device has high charge storage effect.

TABLE 6

| $TiO_2$ (mol%) | Photoelectromotive force ($\mu$V/cm$^2$) |
|---|---|
| 0 | 150 |
| 5 | 700 |
| 10 | 1200 |
| 20 | 1400 |
| 30 | 1150 |
| 40 | 800 |
| 50 | 250 |
| 60 | 0 |
| 80 | 0 |
| 100 | 0 |

Example 14

In accordance with the process of Example 13, each photoelectric device was prepared by blending PbO and $Cr_2O_3$ to give $PbCrO_4$ or $Pb_5CrO_8$ and adding 10 mol% of $TiO_2$.

As a result, the photoelectromotive forces of the devices were respectively, 720 $\mu$V/cm$^2$ in the case of $PbCrO_4$ and 580 $\mu$V/cm$^2$ in the case of $Pb_5CrO_8$.

Example 15

In accordance with the process of Example 14 except using 10 mol% of $SiO_2$ or $ZrO_2$ instead of $TiO_2$, each photoelectric device was prepared and each photoelectromotive force was measured. The results are shown in Table 7.

TABLE 7

| Auxiliary component (10 mol%) | Photoelectromotive force ($\mu$V/cm$^2$) |
|---|---|
| $TiO_2$ | 1200 |
| $SiO_2$ | 1100 |
| $ZrO_2$ | 1150 |

Example 16

Lead oxide PbO and chromium oxide $Cr_2O_3$ were used as starting materials and were weighed to give a ratio for a composition of $Pb_2CrO_5$. As a further component, $Al_2O_3$ was incorporated at a range of 5—80 mol%.

These starting materials were blended in wet condition for 10 to 15 hours in a polyethylene pot. The mixture was dried and calcined at 400 to 500°C for 2 hours. After the calcination, the product was pulverized by a ball mill for 10 to 15 hours to obtain a powder having particle diameter of about 1 $\mu$. The calcined powder was admixed with a binder and the mixture was press-molded under a pressure of 1000 kg/cm$^2$. The molded product was sintered at 650 to 900°C for 2 hours to obtain a sintered product. A photoelectric device is formed by coating an aluminum film on the surface of the sintered product by a vacuum evaporation method. A shape of the device is a disk having a diameter of 20 mm and a thickness of 1 mm and a disk having a diameter of 20 mm and a thickness of 0.1 mm. An electrode having a diameter of 15 mm and a thickness of 0.5 $\mu$m was formed on each of the upper and lower surfaces of the sintered substrate.

Each resulting photoelectric device of the present invention was exposed to laser beam having a laser power of 20 $\mu$W/cm$^2$ at a wavelength of 4880×10$^{-8}$ cm and each photoelectromotive force was measured by a DC voltage meter. The results are shown in Table 8 and plotted in Figure 6.

As it is clearly understood from Table 8 and Figure 6, the maximum value was given in a content of $Al_2O_3$ of about 20 mol% and was higher than 900 $\mu$V/cm$^2$. An electromotive force of the device was measured by masking the device from incident ray. When the thickness of the disk was 0.1 mm, the electromotive force was zero. However, when the thickness of the disk was 1 mm, it was not zero. This fact shows that a thin device has high photosensitivity, whereas a thick device has high charge storage effect.

TABLE 8

| Al$_2$O$_3$ (mol%) | Photoelectromotive force ($\mu$V/cm$^2$) |
|---|---|
| 0 | 150 |
| 5 | 500 |
| 10 | 800 |
| 20 | 900 |
| 30 | 650 |
| 40 | 450 |
| 50 | 250 |
| 60 | 0 |
| 80 | 0 |
| 100 | 0 |

Example 17

In accordance with the process of Example 16, each photoelectric device was prepared by blending PbO and Cr$_2$O$_3$ to give PbCrO$_4$ or Pb$_5$CrO$_8$ and adding 10 mol% of Al$_2$O$_3$.

As a result, the photoelectromotive forces of the devices were respectively, 480 $\mu$V/cm$^2$ in the case of PbCrO$_4$ and 380 $\mu$V/cm$^2$ in the case of Pb$_5$CrO$_8$.

Example 18

In accordance with the process of Example 16 except using 10 mol% of In$_2$O$_3$ instead of Al$_2$O$_3$, each photoelectric device was prepared and each photoelectromotive force was measured. The results are shown in Table 9.

TABLE 9

| Further component (10 mol%) | Photoelectromotive force ($\mu$V/cm$^2$) |
|---|---|
| Al$_2$O$_3$ | 800 |
| In$_2$O$_3$ | 600 |

Example 19

Lead oxide PbO and chromium oxide Cr$_2$O$_3$ were used as starting materials and were weighed to give a ratio for a composition of Pb$_2$CrO$_5$. As a further component, WO$_3$ was incorporated at a range of less than 60 mol%.

These starting materials were blended in wet condition for 10 to 15 hours in a polyethylene pot. The mixture was dried and calcined at 400 to 500°C for 2 hours. After the calcination, the product was pulverized by a ball mill for 10 to 15 hours to obtain a powder having particle diameter of about 1$\mu$. The calcined powder was admixed with a binder and the mixture was press-molded under a pressure of 1000 kg/cm$^2$. The molded product was sintered at 650 to 900°C for 2 hours to obtain a sintered product. A photoelectric device is formed by coating an aluminum film on the surface of the sintered product by a vacuum evaporation method. A shape of the device is a disk having a diameter of 20 mm and a thickness of 1 mm and a disk having a diameter of 20 mm and a thickness of 0.1 mm. An electrode having a diameter of 15 mm and a thickness of 0.5 $\mu$m was formed on each of the upper and lower surfaces of the sintered substrate.

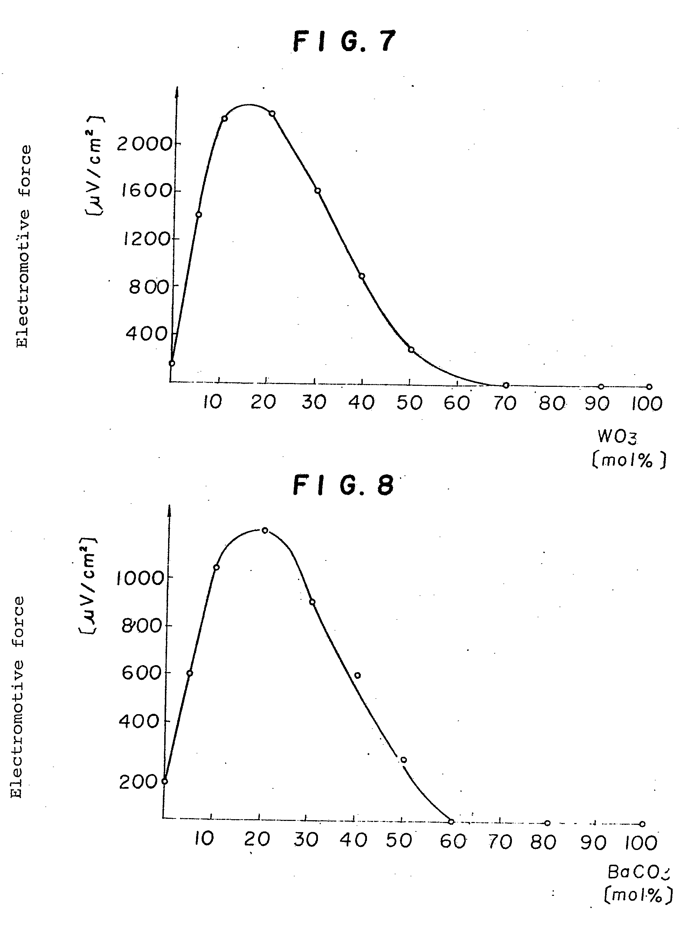

Each resulting photoelectric device of the present invention was exposed to laser beam having a laser power of 20 $\mu$W/cm$^2$ at a wavelength of 4880×10$^{-8}$ cm and each photoelectromotive force was measured by a DC voltage meter. The results are shown in Table 10 and plotted in Figure 7.

As it is clearly understood from Table 10 and Figure 7, the maximum value was given in a content of WO$_3$ of about 20 mol% and was higher than 2250 $\mu$V/cm$^2$. An electromotive force of the device was measured by masking the device from incident ray. When the thickness of the disk was 0.1 mm, the electromotive force was zero. However, when the thickness of the disk was 1 mm, it was not zero. This fact shows that a thin device has high photosensitivity, whereas a thick device has high charge storage effect.

TABLE 10

| WO$_3$ (mol%) | Photoelectromotive force ($\mu$V/cm$^2$) |
|---|---|
| 0 | 150 |
| 5 | 1400 |
| 10 | 2200 |
| 20 | 2250 |
| 30 | 1600 |
| 40 | 900 |
| 50 | 300 |
| 70 | 0 |
| 90 | 0 |
| 100 | 0 |

Example 20

In accordance with the process of Example 19, each photoelectric device was prepared by blending PbO and Cr$_2$O$_3$ to give PbCrO$_4$ or Pb$_5$CrO$_8$ and adding 10 mol% of WO$_3$.

As a result, the photoelectromotive forces of the devices were respectively, 1350 $\mu$V/cm$^2$ in the case of PbCrO$_4$ and 1240 $\mu$V/cm$^2$ in the case of Pb$_5$CrO$_8$.

Example 21

In accordance with the process of Example 19 except using 10 mol% of MoO$_3$ instead of WO$_3$, each photoelectric device was prepared and each photoelectromotive force was measured. As a result, excellent photoelectromotive force of 2100 $\mu$V/cm$^2$ was given in the case of MoO$_3$.

Example 22

Lead oxide PbO and chromium oxide Cr$_2$O$_3$ were used as starting materials and were weighed to give a ratio for a composition of Pb$_2$CrO$_5$. As a further component BaCO$_3$ was incorporated at a range of 5—80 mol%.

These starting materials were blended in wet condition for 10 to 15 hours in a polyethylene pot. The mixture was dried and calcined at 400 to 500°C for 2 hours. After the calcination, the product was pulverized by a ball mill for 10 to 15 hours to obtain a powder having particle diameter of about $1\mu$. The calcined powder was admixed with a binder and the mixture was press-molded under a pressure of 1000 kg/cm². The molded product was sintered at 650 to 900°C for 2 hours to obtain a sintered product. A photoelectric device is formed by coating an aluminum film on the surface of the sintered product by a vacuum evaporation method. A shape of the device is a disk having a diameter of 20 mm and a thickness of 1 mm and a disk having a diameter of 20 mm and a thickness of 0.1 mm. An electrode having a diameter of 15 mm and a thickness of 0.5 $\mu$m was formed on each of the upper and lower surfaces of the sintered substrate.

Each resulting photoelectric device of the present invention was exposed to laser beam having a laser power of 20 $\mu$W/cm² at a wavelength of $4880\times10^{-8}$ cm and each photoelectromotive force was measured by a DC voltage meter. The results are shown in Table 11 and plotted in Figure 8.

As it is clearly understood from Table 11 and Figure 8, the maximum value was given in a content of BaCO₃ of about 20 mol% and was higher than 1200 $\mu$V/cm². An electromotive force of the device was measured by masking the device from incident ray. When the thickness of the disk was 0.1 mm, the electromotive force was zero. However, when the thickness of the disk was 1 mm, it was not zero. This fact shows a thin device has high photosensitivity, whereas a thick device has high charge storage effect.

TABLE 11

| BaCO₃ (mol%) | Photoelectromotive force ($\mu$V/cm²) |
|---|---|
| 0 | 150 |
| 5 | 600 |
| 10 | 1050 |
| 20 | 1200 |
| 30 | 900 |
| 40 | 600 |
| 50 | 250 |
| 60 | 0 |
| 80 | 0 |
| 100 | 0 |

Example 23

In accordance with the process of Example 22, each photoelectric device was prepared by blending PbO and Cr₂O₃ to give PbCrO₄ or Pb₅CrO₈ and adding 10 mol% of BaCO₃.

As a result, the photoelectromotive forces of the devices were respectively, 630 $\mu$V/cm² in the case of PbCrO₄ and 500 $\mu$V/cm² in the case of Pb₅CrO₈.

Example 24

In accordance with the process of Example 22 except using 10 mol% of SrCO₃ or ZnCO₃ instead of BaCO₃, each photoelectric device was prepared and each photoelectromotive force was measured.

In the other test, ZnO was used instead of ZnCO₃. The results are shown in Table 12.

TABLE 12

| Further component (10 mol%) | Photoelectromotive force ($\mu$V/cm²) |
|---|---|
| BaCO₃ | 1050 |
| SrCO₃ | 900 |
| ZnCO₃(ZnO) | 800 |

As described above, the present invention is to provide a photoelectric device in which at least two electroconductive layers are formed on one or more surfaces of the oxide substrate comprising lead oxide and chromium oxide. A process for producing the photoelectric device comprises mixing lead oxide and chromium oxide and sintering the mixture and coating electroconductive layers on the sintered substrate.

Excellent photoelectromotive force is generated. In case of a thin film, excellent photosensitivity is given, whereas in case of a thick plate, charge storage effect is imparted. The elements can be prepared as sintered porcelains by sintering and accordingly, the elements can be prepared in mass production and stable so as to be economical. The photoelectric device has advantageously a high strength and high durability which are not found in conventional photoelectric devices.

It is important to form at least two conductive layers as electrodes on the oxide substrate. The conductive layers are usually formed on both surfaces of the oxide substrate in the form of a sheet or a film.

It is also possible to form separated conductive layers on one surface of the oxide substrate.

The oxide substrate can be formed in various shapes such as a sheet, a rod and a film. It is also possible to form the oxide substrate by a vacuum deposition or by an electron beam method wherein electron beams are radiated to said specific oxides in vacuum to deposit the evaporated oxides on a supporter. The thickness of the oxide substrate can be about 10 $\mu$.

**Claims**

1. A photoelectric device in which an electroconductive layer is formed on one or more surfaces of an oxide substrate comprising a lead component at a ratio of 30—99.5 mol% as PbO and a chromium component at a ratio of 70—0.5 mol% as Cr₂O₃.

2. A photoelectric device according to Claim 1 wherein the oxide substrate comprises a lead component at a ratio of 60—90 mol% as PbO and a chromium component at a ratio of 40—10 mol% as $Cr_2O_3$.

3. A photoelectric device according to Claim 1 or 2 wherein the oxide substrate is a sintered product in a plate form.

4. A photoelectric device according to Claim 3 wherein the electroconductive layer is formed on both surfaces of the sintered product in a plate form.

5. A photoelectric device according to Claim 3 wherein the thickness of the sintered product is less than 0.2 mm.

6. A photoelectric device according to Claim 3 wherein the thickness of the sintered product is greater than 0.2 mm.

7. A photoelectric device according to Claim 1 or 2 wherein the oxide substrate comprises at least one of $Pb_5CrO_8$, $Pb_2CrO_5$ and $PbCrO_4$.

8. A photoelectric device according to one of Claims 1 to 7 wherein the oxide substrate further comprises an auxiliary component of another metal compound.

9. A photoelectric device according to Claim 8 wherein a perovskite composite oxide is incorporated at a ratio of up to 95 mol% based on the total of PbO and $Cr_2O_3$.

10. A photoelectric device according to Claim 9 wherein the perovskite composite oxide is lead titanate or lead zirconate.

11. A photoelectric device according to Claim 8 wherein a monovalent metal compound is incorporated at a ratio of up to 80 mol% as its carbonate based on the total of PbO and $Cr_2O_3$.

12. A photoelectric device according to Claim 11 wherein the monovalent metal is Li, Na, K, Rb, Cs or Cu.

13. A photoelectric device according to Claim 8 wherein a pentavalent metal compound is incorporated at a ratio of up to 55 mol% as $M_2^1O_5$ ($M^1$: metal (V)) based on the total of PbO and $Cr_2O_3$.

14. A photoelectric device according to Claim 13 wherein the pentavalent metal is Nb or Ta.

15. A photoelectric device according to Claim 8 wherein a tetravalent metal compound is incorporated at a ratio of up to 55 mol% as $M^2O_2$ ($M^2$: metal (IV)) based on the total of PbO and $Cr_2O_3$.

16. A photoelectric device according to Claim 15 wherein the tetravalent metal is Ti, Si or Zr.

17. A photoelectric device according to Claim 8 wherein a trivalent metal compound is incorporated at a ratio of up to 55 mol% as $M_2^3O_3$ ($M^3$: metal (III)) based on the total of PbO and $Cr_2O_3$.

18. A photoelectric device according to Claim 17 wherein the trivalent metal is Al or In.

19. A photoelectric device according to Claim 8 wherein a hexavalent metal compound is incorporated at a ratio of up to 60 mol% as $M^4O_3$ ($M^4$: metal (VI)) based on the total of PbO and $Cr_2O_3$.

20. A photoelectric device according to Claim 19 wherein the hexavalent metal is Mo or W.

21. A photoelectric device according to Claim 8 wherein a divalent metal compound is incorporated at a ratio of up to 55 mol% as its carbonate based on the total of PbO and $Cr_2O_3$.

22. A photoelectric device according to Claim 21 wherein the divalent metal is Zn, Sr or Ba.

23. A photoelectric transfer device according to Claim 1 wherein the oxide substrate is formed, as a film deposited by an electron beam method in vacuum.

**Patentansprüche**

1. Photoelektrische Einrichtung, bei der eine elektrisch leitende Schicht auf einer oder mehreren Oberflächen eines Oxidsubstrats ausgebildet ist, welches eine Bleikomponente in einer Menge von 30 bis 99,5 Mol-%, berechnet als PbO, sowie eine Chromkomponente in einer Menge von 70 bis 0,5 Mol-%, berechnet als $Cr_2O_3$, umfaßt.

2. Photoelektrische Einrichtung nach Anspruch 1, wobei das Oxidsubstrat eine Bleikomponente in einer Menge von 60 bis 90 Mol-%, berechnet, als PbO, und eine Chromkomponente in einer Menge von 40 bis 10 Mol-%, berechnet als $Cr_2O_3$, umfaßt.

3. Photoelektrische Einrichtung nach Anspruch 1 oder 2, dadurch gekennzeichnet, daß das Oxidsubstrat ein gesintertes Erzeugnis in Plattenform ist.

4. Photoelektrische Einrichtung nach Anspruch 3, dadurch gekennzeichnet, daß die elektrisch leitfähige Schicht auf beiden Oberflächen des gesinterten Produkts in Plattenform ausgebildet ist.

5. Photoelektrische Einrichtung nach Anspruch 3, dadurch gekennzeichnet, daß die Dicke des gesinterten Erzeugnisses weniger als 0,2 mm beträgt.

6. Photoelektrische Einrichtung nach Anspruch 3, dadurch gekennzeichnet, daß die Dicke des gesinterten Erzeugnisses größer als 0,2 mm ist.

7. Photoelektrische Einrichtung nach Anspruch 1 oder 2, dadurch gekennzeichnet, daß das Oxidsubstrat mindestens eine der Komponenten $Pb_5CrO_8$, $Pb_2CrO_5$ und $PbCrO_4$ umfaßt.

8. Photoelektrische Einrichtung nach einem der Ansprüche 1 bis 7, dadurch gekennzeichnet, daß das Oxidsubstrat zusätzlich als Hilfskomponente eine andere Metallverbindung enthält.

9. Photoelektrische Einrichtung nach Anspruch 8, wobei ein zusammengesetztes Perovskitoxid in einer Menge von bis zu 95 Mol-%, bezogen auf die Gesamtmenge von PbO und $Cr_2O_3$, einverleibt ist.

10. Photoelektrische Einrichtung nach Anspruch 9, wobei das zusammengesetzte Perovskitoxid Bleititanat oder Bleizirkonat ist.

11. Photoelektrische Einrichtung nach Anspruch 8, wobei eine einwertige Metallverbindung in einer Menge von bis zu 80 Mol-%, berechnet als Carbonat und bezogen auf die Gesamtmenge von PbO und $Cr_2O_3$, einverleibt ist.

12. Photoelektrische Einrichtung nach Anspruch 11, wobei das einwertige Metall Li, Na, K, Rb, Cs oder Cu ist.

13. Photoelektrische Einrichtung nach Anspruch 8, wobei eine fünfwertige Metallverbindung in einer Menge von bis zu 55 Mol-%, berechnet als $M^1_2O_5$, wobei $M^1$ ein fünfwertiges Metall bedeutet, und bezogen auf die Gesamtmenge an PbO und $Cr_2O_3$, einverleibt ist.

14. Photoelektrische Einrichtung nach Anspruch 13, wobei das fünfwertige Metall Nb oder Ta ist.

15. Photoelektrische Einrichtung nach Anspruch 8, wobei eine vierwertige Metallverbindung in einer Menge von bis zu 55 Mol-%, berechnet als $M^2O_2$, wobei $M^2$ ein vierwertiges Metall bedeutet, und bezogen auf die Gesamtmenge an PbO und $Cr_2O_3$, einverleibt ist.

16. Photoelektrische Einrichtung nach Anspruch 15, wobei das vierwertige Metall Ti, Si oder Zr ist.

17. Photoelektrische Einrichtung nach Anspruch 8, wobei eine dreiwertige Metallverbindung in einer Menge von bis zu 55 Mol-%, berechnet als $M^3_2O_3$, wobei $M^3$ ein dreiwertiges Metall bedeutet, und bezogen auf die Gesamtmenge an PbO und $Cr_2O_3$, einverleibt ist.

18. Photoelektrische Einrichtung nach Anspruch 17, wobei das dreiwertige Metall Al or In ist.

19. Photoelektrische Einrichtung nach Anspruch 8, wobei eine sechswertige Metallverbindung in einer Menge von bis zu 60 Mol-%, berechnet als $M^4O_3$, wobei $M^4$ ein vierwertiges Metall bedeutet, und bezogen auf die Gesamtmenge an PbO und $Cr_2O_3$, einverleibt ist.

20. Photoelektrische Einrichtung nach Anspruch 19, wobei das sechswertige Metall Mo oder W ist.

21. Photoelektrische Einrichtung nach Anspruch 8, wobei eine zweiwertige Metallverbindung in einer Menge von bis zu 55 Mol-%, berechnet als Carbonat und bezogen auf die Gesamtmenge an PbO und $Cr_2O_3$, einverleibt ist.

22. Photoelektrische Einrichtung nach Anspruch 21, dadurch gekennzeichnet, daß das zweiwertige Metall Zn, Sr oder Ba ist.

23. Photoelektrische Einrichtung nach Anspruch 1, wobei das Oxidsubstrat als Film vorliegt, welcher im Vakuum nach dem Elektronenstrahlverfahren abgeschieden wurde.

**Revendications**

1. Dispositif photoélectrique, caractérisé en ce qu'une couche électroconductrice est réalisée sur une ou plusieurs surfaces d'un substrat d'oxyde comprenant un composant de plomb dans une proportion comprise entre 30 et 99,5 moles % sous la forme de PbO et un composant de chrome dans une proportion comprise entre 70 et 0,5 moles % sous forme de $Cr_2O_3$.

2. Dispositif photoélectrique selon la revendication 1, caractérisé en ce que le substrat d'oxyde comprend un composant de plomb dans une proportion comprise entre 60 et 90 moles % sous la forme de PbO et un composant de chrome dans une proportion comprise entre 40 et 10 moles % sous la forme de $Cr_2O_3$.

3. Dispositif selon la revendication 1 ou 2, caractérisé en ce que le substrat d'oxyde est un produit fritté sous forme de plaque.

4. Dispositif photoélectrique selon la revendication 3, caractérisé en ce que la couche électroconductrice est réalisée sur les deux surfaces du produit fritté sous forme de plaque.

5. Dispositif photoélectrique selon la revendication 3, caractérisé en ce que l'épaisseur du produit fritté est inférieure à 0,2 mm.

6. Dispositif photoélectrique selon la revendication 3, caractérisé en ce que l'épaisseur du produit fritté est supérieure à 0,2 mm.

7. Dispositif photoélectrique selon la revendication 1 ou 2, caractérisé en ce que le substrat d'oxyde comprend au moins une des substances suivantes $Pb_5CrO_8$, $Pb_2CrO_5$ et $PbCrO_4$.

8. Dispositif photoélectrique selon l'une quelconque des revendications 1 à 7, caractérisé en ce que le substrat d'oxyde comprend en outre un composant auxiliaire d'un autre composé métallique.

9. Dispositif photoélectrique selon la revendication 8, caractérisé en ce qu'un oxyde composé de pérovskite est incorporé dans une proportion allant jusqu'à 95 moles % sur la base de la totalité du PbO et du $Cr_2O_3$.

10. Dispositif photoélectrique selon la revendication 9, caractérisé en ce que l'oxyde composé de pérovskite est le titanate de plomb ou le zirconate de plomb.

11. Dispositif photoélectrique selon la revendication 8, caractérisé en ce qu'un composé métallique monovalent est incorporé dans une proportion allant jusqu'à 80 moles % sous la forme de son carbonate sur la base de la totalité du PbO et du $Cr_2O_3$.

12. Dispositif photoélectrique selon la revendication 11, caractérisé en ce que le métal monovalent est constitué par Li, Na, K, Rb, Cs ou Cu.

13. Dispositif photoélectrique selon la revendication 8, caractérisé en ce que le composé métallique pentavalent est incorporé dans une proportion allant jusqu'à 55 moles % sous la forme de $M^1_2O_5$ ($M^1$:métal (V)) sur la base de la totalité de PbO et de $Cr_2O_3$.

14. Dispositif photoélectrique selon la revendication 13, caractérisé en ce que le métal pentavalent est constitué par Nb ou Ta.

15. Dispositif photoélectrique selon la revendication 8, caractérisé en ce qu'un composé métallique tétravalent est incorporé dans une proportion allant jusqu'à 55 moles % sous la forme de $M^2O_2$ ($M^2$: métal (IV)) sur la base de la totalité de PbO et de $Cr_2O_3$.

16. Dispositif photoélectrique selon la revendication 15, caractérisé en ce que le métal tétravalent est constitué par Ti, Si ou Zr.

17. Dispositif photoélectrique selon la revendication 8, caractérisé en ce qu'un composé métallique trivalent est incorporé dans une proportion allant jusqu'à 55 moles % sous la forme de $M^3_2O_3$ ($M^3$: métal (III)) sur la base de la totalité de PbO et de $Cr_2O_3$.

18. Dispositif photoélectrique selon la revendication 17, caractérisé en ce que le métal trivalent est constitué par Al ou In.

19. Dispositif photoélectrique selon la revendication 8, caractérisé en ce qu'un composé métallique hexavalent est incorporé dans une proportion allant jusqu'à 60 moles % sous la forme de $M^4O_3$ ($M^4$: métal (VI)) sur la base de la totalité de PbO et de $Cr_2O_3$.

20. Dispositif photoélectrique selon la revendication 19, caractérisé en ce que le métal hexavalent est constitué par Mo ou W.

21. Dispositif photoélectrique selon la revendication 8, caractérisé en ce qu'un composé métallique divalent est incorporé dans une proportion allant jusqu'à 55 moles % sous la forme de son carbonate sur la base de la totalité de PbO et de $Cr_2O_3$.

22. Dispositif photoélectrique selon la revendication 21, caractérisé en ce que le métal divalent est constitué par Zn, Sr ou Ba.

23. Dispositif photoélectrique selon la revendication 1, caractérisé en ce que le substrat d'oxyde est réalisé sous forme d'une couche déposée sous vide par un procédé utilisant un faisceau d'électrons.

0011083

FIG. 1

FIG. 2

FIG. 3

1

0011083

FIG. 4

Electromotive force [μV/cm²]

Nb₂O₆ [mol%]

FIG. 5

Electromotive force [μV/cm²]

TiO₂ [mol%]

FIG. 6

Electromotive force [μV/cm²]

Al₂O₃ [mol%]

2

0011083

# F I G. 7

# F I G. 8